Europäisches Patentamt

European Patent Office

Office européen des brevets

(19)

(11) Numéro de publication : **0 145 567**
**B1**

(12) **FASCICULE DE BREVET EUROPÉEN**

(45) Date de publication du fascicule du brevet :
30.09.87

(21) Numéro de dépôt : 84402365.5

(22) Date de dépôt : 20.11.84

(51) Int. Cl.⁴ : **H 01 L 29/60**, H 01 L 29/78

(54) Transistor à effet de champ à structure verticale.

(30) Priorité : 25.11.83 FR 8318847

(43) Date de publication de la demande :
19.06.85 Bulletin 85/25

(45) Mention de la délivrance du brevet :
30.09.87 Bulletin 87/40

(84) Etats contractants désignés :
DE GB NL

(56) Documents cités :
EP-A- 0 051 504
FR-A- 2 230 082
US-A- 4 262 296
JOURNAL OF THE ELECTROCHEMICAL SOCIETY,
vol. 117, no. 11, novembre 1970, pages 1410-1417,
Princeton, US; J.E. FOSTER et al.: "Electrical characteristics of the silicon nitride-gallium arsenide interface"
ELECTRONICS LETTERS, vol. 19, no. 12, 9 juin 1983,
pages 434-435, Londres, GB; E. KOHN et al.: "MIM
gate FET: new GaAs enhancement-mode transistor"

(73) Titulaire : THOMSON-CSF
173, Boulevard Haussmann
F-75379 Paris Cedex 08 (FR)

(72) Inventeur : Kohn, Erhard
THOMSON-CSF SCPI 173, bld Haussmann
F-75379 Paris Cedex 08 (FR)
Inventeur : Dortu, Jean-Marc
THOMSON-CSF SCPI 173, bld Haussmann
F-75379 Paris Cedex 08 (FR)

(74) Mandataire : Taboureau, James et al
THOMSON-CSF SCPI 19, avenue de Messine
F-75008 Paris (FR)

Jouve, 18, rue St-Denis, 75001 Paris, France

### Description

La présente invention concerne un transistor à effet de champ de type MIS fonctionnant en désertion profonde à structure verticale, travaillant dans le domaine des ondes millimétriques. Les transistors classiques utilisés pour cette application sont les Mesfets. La différence présentée par rapport à ces derniers est que les régions parasites d'accès à la région de source et à la région de drain, qui sur un transistor classique ne sont pas modulées par la grille, sont supprimées. Cet objectif est atteint grâce à une électrode de grille s'étendant tout le long du canal : pour éviter les courts-circuits entre la métallisation de grille et les régions de source et drain, la métallisation de grille est déposée sur une couche diélectrique, qui recouvre les flancs des couches de source, grille et drain. Le transistor ainsi réalisé, sans régions parasites d'accès, fonctionne préférentiellement en régime balistique. La couche diélectrique est en matériaux présentant une fuite électrique, ce qui permet, ajouté à d'autres précautions connues de l'homme de l'art, de réaliser un transistor à effet de champ dont la fréquence de coupure est largement supérieure à 100 GHz, sans hystérisis dans les caractéristiques de courant en fonction de la tension.

Dans les transistors verticaux, la métallisation de grille n'est pas facile à réaliser. Si elle est déposée sur un flanc de la couche active, limitée par gravure sous la métallisation de drain, il est très difficile de contrôler la hauteur de métal sur le flanc de la couche active, pour éviter les court-circuits entre métallisation de grille et de drain.

Le transistor selon l'invention comporte un substrat sur lequel ont été déposées au moins deux couches de matériaux semiconducteurs, soit une couche active, dans laquelle se développe le canal de conduction, et une couche de faible résistance supportant une métallisation d'accès, de drain par exemple. Ces deux couches sont gravées sur toute leur épaisseur et le substrat en partie, de façon à créer une mésa, et le substrat est rendu semi-isolant autour du pied de la mésa par implantation. Une couche d'un matériau diélectrique est déposée sur les flancs de la mésa et sur le substrat autour du pied de la mésa : cette couche recouvre donc les flancs des deux couches active et de drain. La métallisation de grille est déposée sur la couche de matériau diélectrique : elle peut sans inconvénient recouvrir en partie les flancs des deux régions d'accès, c'est-à-dire source et drain, puisqu'elle en est séparée par une couche diélectrique. Mais, en s'étendant sur toute la longueur du canal de conduction, la métallisation de grille supprime les régions parasites d'accès, c'est-à-dire les régions situées entre les métallisations de grille et de source et drain qui, dans un transistor classique, ne sont pas modulées par la grille.

De façon plus précise l'invention concerne un transistor à effet de champ à structure verticale, comportant, supportées par un substrat en matériau semiconducteur, au moins une première couche fortement dopée, une seconde couche peu dopée et une troisième couche fortement dopée, la première et la troisième couches formant les régions d'accès inférieure et supérieure dites source et drain, dont les métallisations de contact sont portées l'une par la face arrière du substrat, l'autre par la troisième couche, la troisième et la seconde couches formant une mésa sur les flancs de laquelle est déposé le dispositif d'électrode de grille qui module le canal dans la seconde couche, ce transistor à effet de champ étant caractérisé en ce que, en vue de supprimer les régions parasites d'accès de source et drain, l'épaisseur de la seconde couche dans laquelle se développe le canal du transistor est entièrement contrôlée par la métallisation de grille qui est au moins aussi longue que l'épaisseur de ladite seconde couche, et qui recouvre partiellement au moins la troisième couche, et en ce que ladite métallisation est séparée de la troisième couche par une couche d'un matériau diélectrique présentant une fuite électrique, déposée sur les flancs de la mésa.

L'invention sera mieux comprise par la description d'un exemple de réalisation, laquelle s'appuie sur les figures jointes en annexe qui représentent :

figure 1 coupe schématique d'un transistor à effet de champ vertical selon l'art connu,

figure 2 schéma de principe d'un transistor à effet de champ vertical selon l'invention,

figure 3 coupe d'un transistor à effet de champ selon l'invention,

figure 4 agrandissement partiel de la figure 3.

Bien que l'invention s'applique à de nombreux types de transistors à effet de champ, elle sera exposée en s'appuyant sur le cas plus précis, et plus intéressant en regard de la technique mise en œuvre, d'un transistor balistique réalisé dans des matériaux de la famille III-V, c'est-à-dire de type GaAs, AlGaAs... etc. De plus et bien que dans un transistor à effet de champ le rôle de la source et du drain soit souvent interchangeable, on conviendra de façon à simplifier le texte et les dessins que la source du transistor est au substrat et le drain est constitué par les régions épitaxiées supérieures et par la métallisation supérieure. Bien entendu l'invention s'applique à tous types de transistors qui ne seraient pas uniquement balistiques et aux transistors pour lesquels le drain serait au substrat et la source constituée par les couches épitaxiées supérieures.

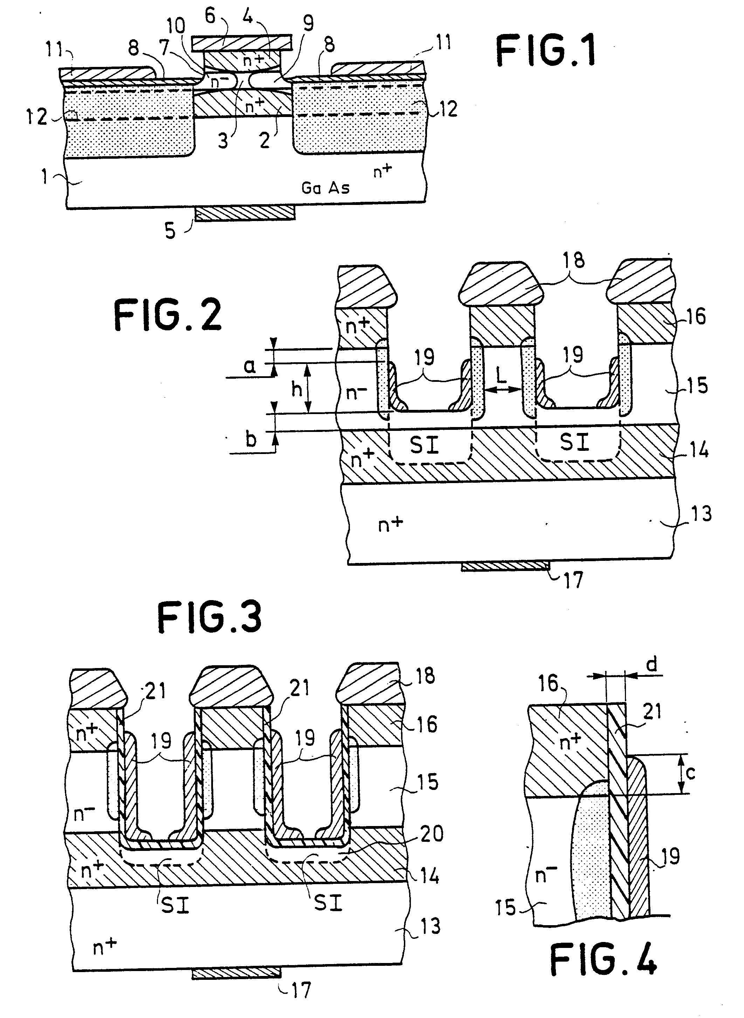

La figure 1 représente la coupe schématique d'un transistor à effet de champ vertical selon l'art connu. Celui-ci est constitué notamment par un substrat 1, qui, dans le domaine des fréquences concernées par l'invention est préférentiellement en matériau de type GaAs de conductivité $n^+$. Le substrat 1 supporte une couche 2 de GaAs $n^+$ qui constitue la région de source du transistor, puis une couche 3 de type $n^-$ dans laquelle se développe le canal du transistor et une couche 4 de type n+ qui constitue la région de drain du transistor. Les contacts de source et de drain sont pris par des métallisations 5 et 6 déposées sur les deux faces opposées de la plaquette dans laquelle est fabriqué le transistor à effet de champ.

La couche 3 de type n⁻ est attaquée sur le pourtour de la région formant le transistor de telle sorte qu'une courbure 7 se développe au pied du mésa constitué essentiellement par la région de drain. Une métallisation 8 est déposée sur la face laissée libre de la couche 3, mais cette métallisation doit être déposée avec beaucoup de soin de telle façon qu'elle ne remonte pas le long de la courbure ce qui court-circuiterait la région n+ 4 du drain. Lorsqu'une tension est appliquée sur la métallisation de grille 8, le champ développé crée deux zones 9 et 10, entre lesquelles le canal est plus ou moins contracté, ce qui permet la commande du transistor.

Accessoirement, des métallisations épaisses 11 sont rapportées sur la métallisation de grille 8, et des caissons 12 sont formés dans la couche de source et partiellement dans le substrat de façon à délimiter la région utile du transistor à effet de champ vertical.

Ce transistor est intéressant dans le sens où la distance entre région de source et région de drain n'est plus définie en fonction des moyens techniques de masquage dont on dispose, mais est définie par l'épaisseur de la couche 3, et l'on peut sans difficulté déposer des épaisseurs épitaxiées de l'ordre de 100 nm (1 000 angströms), bien plus facilement que par masquage plan horizontal.

Cependant ce transistor est relativement délicat à réaliser car il est important que la métallisation 8 qui assure le contact avec les deux régions 9 et 10 dans la couche active du transistor, ne déborde pas de cette couche ce qui assurerait un court-circuit avec la région de drain 4.

La figure 2 représente le schéma de principe d'un transistor à effet de champ selon l'invention, et constitue une étape préliminaire au transistor pour lequel une protection est demandée.

Cependant quelques explications préliminaires permettront de mieux comprendre le problème à résoudre dans le cadre de l'invention. Le transistor sur lequel on a choisi d'exposer l'invention est un transistor balistique, dont les régions de source et de drain sont fortement dopées de type n+. Le canal est une région faiblement dopée de type n⁻, ou intrinsèque, d'une hauteur h submicronique de l'ordre de 200 nm (2 000 angströms) par exemple. La modulation du canal s'effectue par une grille fixée sur le canal. Il est connu que la largeur L du canal est un paramètre relativement peu critique, tandis que la hauteur h doit être très faible, en tout cas submicronique, pour que le transistor puisse fonctionner en régime balistique. De toute façon pour qu'un transistor fonctionne dans une gamme très élevée d'hyperfréquence, il est important que la hauteur h du canal soit courte, et c'est la raison pour laquelle la structure verticale a été retenue. Par ailleurs il est connu que les distances a et b séparant respectivement l'électrode de grille de la région de drain et l'électrode de grille de la région de source doivent être très faibles pour obtenir une transconductance $g_m$ maximale : ces distances a et b sont avantageusement de l'ordre de quelques dizaines de nanomètres (centaines d'angströms). Ces régions, non contrôlées par la grille, introduisent des longueurs de parcours parasites qui réduisent sensiblement les performances d'un transistor, si elles perturbent le comportement balistique.

Il est difficile de réduire cette distance dans le cas d'un contact Schottky à cause des fuites qui apparaissent et parce qu'il est difficile de mettre au point une technique de positionnement précis du contact Schottky.

La figure 2 représente le schéma de principe d'un transistor à effet de champ selon l'invention. Ce transistor comporte, supporté par un substrat 13 de type n+ par exemple, une couche épitaxiée 14 de type n+ également qui constitue la région de source, puis une couche 15 de type n⁻ qui constitue la région du canal et enfin une couche 16 de type n+ qui constitue la région de drain. Les deux couches épitaxiées supérieures c'est-à-dire la couche 15 n⁻ et la couche 16 n+ sont gravées sur une profondeur qui est sensiblement supérieure à leur hauteur totale, de sorte que la gravure atteind la première couche épitaxiée 14, et l'attaque partiellement : une implantation par des protons dans le fond des sillons de gravure rend une partie de la couche 14 semi-isolante de façon à éviter les problèmes capacitifs entre la future métallisation de grille et la couche n+, et de façon également à éviter que cette métallisation ne présente des courts-circuits grille/source.

Dans une première étape des travaux qui ont abouti aux transistors selon l'invention, des métallisations 17 de source et 18 de drain ont été déposées sur les deux faces de la plaquette dans laquelle sont réalisés collectivement les transistors. Puis des métallisations 19 de grille ont été projetées dans le fond des sillons de façon à constituer les métallisations de grille, en utilisant la technique de la projection oblique qui permet dans une certaine mesure de régler la hauteur de la métallisation 19 le long d'une paroi verticale par rapport au substrat. En fait, cette technique de métallisation oblique ne permet pas de bien contrôler la distance « a » séparant le haut de la métallisation 19 de la face inférieure de la couche 16 n+ de la région de drain. En effet les dimensions sont de l'ordre d'un micromètre pour l'ouverture du sillon et d'un micromètre au maximum pour la profondeur de ce même sillon puisque la couche 15 ou couche active dans laquelle se développe le canal du transistor n'a une épaisseur que de l'ordre de 100 à 200 nm (1 000 à 2 000 angströms). Il est très difficile à une telle échelle de contrôler la distance « a », qui doit être inférieure à 150 nm (1 500 angströms), et à tout le moins supérieure à 30 nm (300 angströms).

La figure 3 représente le transistor selon l'invention, et elle comporte l'amélioration apportée qui a permis de résoudre le problème de suppression des régions parasites d'accès entre la région de grille et les régions de source et de drain. Sur la figure 3 ont été conservés les mêmes indices de repère que sur la figure 2 lorsqu'ils désignent les mêmes objets. En outre, de même que la figure 2, la figure 3 représente non pas un transistor à effet de champ isolé mais une partie de la plaquette de matériau semiconducteur dans laquelle sont fabriqués collectivement les transistors selon l'invention.

Le transistor selon l'invention comporte donc supporté par un substrat 13 de type n$^+$, une première couche 14 de source de type n$^+$, une seconde couche de grille 15 de type n$^-$ et une troisième couche de drain 16 de type n$^+$. Des sillons creusés dans les couches de drain 16 et de grille 15 permettent d'isoler une mésa, qui constituera la partie de commande d'un transistor. Les régions 20 situées dans les premières et secondes couches 14 et 15 peuvent être avantageusement implantées par bombardement de protons pour les rendre semi-isolantes.

Avant de procéder aux métallisations de source 17 et de drain 18, l'invention consiste à déposer sur les flancs des sillons une couche 21 d'un matériau diélectrique d'une épaisseur contrôlée, cette couche d'un matériau diélectrique présentant une fuite électrique. Puis les métallisations 19 de grille sont déposées sur les flancs des sillons, en utilisant préférentiellement la technique de projection latérale. En effet il a été dit plus haut que cette technique ne permet pas de contrôler parfaitement la distance « a » qui doit séparer l'électrode de grille de la région de drain, ce qui est un inconvénient, mais par contre, cette technique permet de ne pas déposer de métal dans le fond du sillon, et de diminuer l'effet capacitif entre la couche de métal de l'électrode de grille, si elle occupait le fond du sillon, et la couche semiconductrice 14.

La figure 4 qui constitue l'agrandissement d'un détail de la figure 3 permettra de mieux comprendre le fonctionnement de l'invention. En premier lieu, alors qu'en théorie une distance « a » nulle entre la métallisation de grille et la région de drain serait optimale s'il n'y avait pas de court-circuit, cette condition est remplie parce que la métallisation de grille 19 recouvre sur une distance « c » la région de drain 16. La précision avec laquelle ce recouvrement est obtenu est sans importance, à la condition qu'il n'y ait pas de contact direct entre grille et drain.

En second lieu, la recherche d'une distance connue et contrôlée séparant la métallisation de grille 19 de la région de drain 16 est obtenue par l'épaisseur « d » de la couche de matériau diélectrique 21. Or on sait déposer par différents procédés connus de l'homme de l'art des couches dont l'épaisseur est parfaitement bien contrôlée à quelques dix nanomètres (cent angströms) près, comprise entre 30 et 150 nm (300 et 1 500 angströms).

Enfin, étant donné que les transistors de type MOS c'est-à-dire métal/oxyde/semiconducteur ne sont pas réalisables dans les matériaux de la famille III-V tel que GaAs, et que la présence d'oxygène est néfaste avec le GaAs, il est intéressant d'utiliser pour réaliser la couche de diélectrique 21 un matériau présentant une fuite électrique contrôlable, qui permet de mettre en équilibre électrique les états de surface des couches actives 15 et de drain 16 avec la métallisation 19 de la grille. Toutefois, la fuite électrique dans le matériau 21 est suffisamment faible pour ne pas interférer avec le courant du canal. Dans ces conditions le champ électrique de grille, représenté sur les figures 2 et 3 par des zones pointillées, n'est pas bloqué par l'interface GaAs matériau diélectrique, et il sert entièrement à la modulation du canal ce qui permet d'atteindre une transconductance $g_m$ élevée. En outre, puisque le matériau de la couche 21 permet au transistor d'atteindre plus rapidement ces états d'équilibre, elle permet également de fonctionner à de plus hautes fréquences. Un matériau intéressant pour cette réalisation de transistor vertical est par exemple le nitrure de silicium non stœchiométrique, de type $Si_xN_y$ avec $x/3 > y/4$, ce matériau diélectrique étant éventuellement dopé par un métal qui permet de contrôler la fuite électrique à travers la couche. Le transistor selon l'invention a une transconductance $g_m$ de l'ordre de 1 000 milli siemens, résultat très avantageux par rapport aux transistors selon l'art connu qui ont une transconductance de l'ordre de 100 milli siemens.

Le transistor selon l'invention est utilisé notamment pour faire des circuits intégrés sur des matériaux du type arséniure de gallium, dans lesquels plusieurs transistors de petites dimensions sont implantés sur une même plaquette de matériaux semiconducteurs.

Bien entendu, la description de l'invention en s'appuyant sur un cas précis de transistors balistiques sur arséniure de gallium ne limite pas l'invention à ce seul exemple, l'invention étant précisée de façon plus générale par les revendications suivantes.

**Revendications**

1. Transistor à effet de champ à structure verticale, comportant, supportées par un substrat (13) en matériau semiconducteur, au moins une première couche (14) fortement dopée, une seconde couche (15) peu dopée et une troisième couche (16) fortement dopée, la première (14) et la troisième (16) couches formant les régions d'accès inférieure et supérieure dites source et drain, dont les métallisations de contact sont portées l'une (17) par la face arrière du substrat (13), l'autre (18) par la troisième couche (16), la troisième (16) et la seconde (15) couches formant une mésa sur les flancs de laquelle est déposé le dispositif d'électrode de grille (19) qui module le canal dans la seconde couche (15), ce transistor à effet de champ étant caractérisé en ce que, en vue de supprimer les régions parasites d'accès de source et drain, l'épaisseur de la seconde couche (15) dans laquelle se développe le canal du transistor est entièrement contrôlée par la métallisation de grille (19) qui est au moins aussi longue (h) que l'épaisseur de ladite seconde couche (15), et qui recouvre partiellement (c) au moins la troisième couche (16), et en ce que ladite métallisation (19) est séparée de la troisième couche (16) par une couche d'un matériau diélectrique (21) présentant une fuite électrique, déposée sur les flancs de la mésa.

2. Transistor à effet de champ selon la revendication 1, caractérisé en ce que le transistor est de type balistique, réalisé dans un matériau semiconducteur de la famille III-V tel que GaAs, la première couche (14) étant dopée de type n$^+$, la seconde couche (15) de type n$^-$, la troisième couche (16) de type n$^+$, la seconde couche (15) ayant de plus une épaisseur submicronique de l'ordre de 200 nm.

3. Transistor à effet de champ selon la revendication 1, caractérisé en ce que l'épaisseur (d) de la couche diélectrique (21) et la longueur (c) de recouvrement de la troisième couche (16) par l'électrode de grille (19) sont comprises entre 30 nm et 150 nm.

4. Transistor à effet de champ selon la revendication 1, caractérisé en ce que la couche de matériau diélectrique (21) présentant une fuite électrique qui met en équilibre les états d'interface semiconducteurs-métal, est un nitrure de silicium son stoechiométrique $Si_xN_y$, avec $x/3 > y/4$, dopé par un métal.

5. Transistor à effet de champ selon la revendication 1, caractérisé en ce que au moins une partie de la première couche (14), au pied de la mésa formée par la deuxième (15) et la troisième (16) couches, est rendue semi-isolante par implantation protonique.

6. Transistor à effet de champ selon la revendication 1, caractérisé en ce que la première couche (14) et la métallisation (17) de substrat constituent respectivement la région et l'électrode de source, et en ce que la troisième couche (16) et la métallisation (18) qu'elle supporte constituent respectivement la région et l'électrode de drain.

**Claims**

1. A field effect transistor having a vertical structure and comprising, on a substrate (13) made of semiconductor material, at least one first layer (14) of a high doping rate, a second layer (15) of a low doping rate and a third layer (16) of a high doping rate, the first layer (14) and the third layer (16) constituting the lower and upper access zones, called source and drain, the contact metallisations (17, 18) of which are respectively supported by the rear surface of the substrate (13) and by the third layer (16), the third and the second layers (16, 15) constituting a mesa, the gate electrode device (19) being deposited on the slopes of the mesa and modulating the channel in the second layer (15), characterized in that in order to suppress the parasitic source and drain access zones, the thickness of the second layer (15) in which the transistor channel is made up, is entirely controlled by the gate metallisation (19) which is at least as long (h) as the thickness of the second layer (15) and which in part (c) covers at least the third layer (16), and that said metallisation (19) is separated from the third layer (16) by a layer of a dielectric material (21) having an electrical leak and being deposited on the slopes of the mesa.

2. A field effect transistor according to claim 1, characterized in that the transistor is a ballistic transistor realized in a semiconductor material of the family III-V such as GaAs, the first layer (14) being n$^+$ doped, the second layer (15) being n$^-$ doped, the third layer (16) being n$^+$ doped, the second layer (15) further having a thickness below one micrometer and in the order of 200 nm.

3. A field effect transistor according to claim 1, characterized in that the thickness (d) of the dielectric layer (21) and the overlap length (c) of the third layer (16) covered by the gate electrode (19) are selected between 30 and 150 nm.

4. A field effect transistor according to claim 1, characterized in that the layer of dielectric material (21) having an electrical leak for equilibrating the interface states between semiconductor and metal surfaces is made of non-stoichiometric and metal-doped silicon nitride $Si_xN_y$, $x/3$ being greater than $y/4$.

5. A field effect transistor according to claim 1, characterized in that at least a portion of the first layer (14) at the basis of the mesa constituted by the second and third layers (15, 16) is rendered semi-insulating by proton implantation.

6. A field effect transistor according to claim 1, characterized in that the first layer (14) and the metallisation (17) of the substrate respectively constitute the source zone and the source electrode, and that the third layer (16) and its metallisation (18) respectively constitute the drain zone and the drain electrode.

**Patentansprüche**

1. Feldeffekttransistor mit vertikaler Struktur, der auf einem Substrat (13) aus Halbleitermaterial mindestens eine erste stark dotierte Schicht (14), eine zweite schwach dotierte Schicht (15) und eine dritte stark dotierte Schicht (16) aufweist, wobei die erste und die dritte Schicht (14, 16) untere und obere Zugangszonen bilden, die Source und Drain genannt werden und deren Kontaktmetallisierungen einerseits (17) auf der Rückseite des Substrats (13) und andererseits (18) auf der dritten Schicht (16) liegen, wobei die dritte und die zweite Schicht (16, 15) einen Tafelberg bilden, an dessen Flanken die Gate-Elektrodenvorrichtung (15) angelegt ist, die den Kanal in der zweiten Schicht (15) moduliert, dadurch gekennzeichnet, daß zur Unterdrückung der parasitären Source- und Drain-Zugangszonen die Dicke der zweiten Schicht (15), in der sich der Kanal des Transistors ausbildet, vollkommen durch die Metallisierung der Gate-Elektrode (19) kontrolliert wird, die mindestens ebenso lang (h) wie die zweiten Schicht (15) dick ist und die teilweise (c) mindestens die dritte Schicht (16) bedeckt, und daß diese Metallisierung (19) gegenüber der dritten Schicht (16) durch eine Schicht aus einem dielektrischen Material (21) getrennt ist, das einen elektrischen Fehlstrom leitet und auf die Flanken des Vorsprungs aufgebracht ist.

2. Feldeffekttransistor nach Anspruch 1, dadurch gekennzeichnet, daß der Transistor vom ballistischen Typ ist und aus einem Halbleitermaterial der Familie III-V wie z. B. GaAs gebildet wird, wobei die erste Schicht (14) $n^+$-dotiert ist, die zweite Schicht (15) $n^-$-dotiert ist, die dritte Schicht (16) $n^+$-dotiert ist und die zweite Schicht (15) außerdem eine Dicke unter einem Mikrometer, nämlich in der Größenordnung von 200 nm besitzt.

3. Feldeffekttransistor nach Anspruch 1, dadurch gekennzeichnet, daß die Dicke (d) der dielektrischen Schicht (21) und die Länge (c) der Bedeckung der dritten Schicht (16) mit der Gate-Elektrode (19) zwischen 30 und 150 nm liegen.

4. Feldeffekttransistor nach Anspruch 1, dadurch gekennzeichnet, daß die Schicht aus dielektrischem Material (21), die einen elektrischen Fehlstrom leitet und die Übergangsflächen zwischen Halbleitermaterial und Metall in Gleichgewicht bringt, aus nicht stoechiometrischem Siliciumnitrid $Si_xN_y$ ist, das mit einem Metal dotiert ist, wobei $x/3 > y/4$.

5. Feldeffekttransistor nach Anspruch 1, dadurch gekennzeichnet, daß mindestens ein Teil der ersten Schicht (14) am Fuß des von der zweiten und der dritten Schicht (15, 16) gebildeten Tafelbergs durch Protonenimplantierung halbisolierend gemacht ist.

6. Feldeffekttransistor nach Anspruch 1, dadurch gekennzeichnet, daß die erste Schicht (14) und die Substrat-Metallisierung (17) die Sourcezone bzw. die Source-Elektrode bilden und daß die dritte Schicht (16) und die auf ihr liegende Metallisierung (18) die Drainzone bzw. die Drain-Elektrode bilden.

# FIG.1

# FIG.2

# FIG.3

# FIG.4

1